# EUROPÄISCHE PATENTANMELDUNG

(11) **EP 1 407 897 A1**
(43) Veröffentlichungstag der Anmeldung: **14.04.2004**
(21) Anmeldenummer: 03020033.1
(22) Anmeldetag: 04.09.2003
(51) Int. Cl.: B42D 15/10, G09F 3/02, G03H 1/02, G07D 7/12, G03F 7/20, G03F 7/26

(54) **Mehrschichtfolie mit UV-Lackschicht**

(30) Priorität: 09.10.2002 DE 10247011
(71) Anmelder: Leonhard Kurz GmbH & Co. KG, 90763 Fürth (DE)
(72) Erfinder: May, Marko, 92237 Sulzbach-Rosenberg (DE)
(74) Vertreter: LOUIS- PÖHLAU- LOHRENTZ

(57) **Zusammenfassung**

Die Erfindung betrifft ein Verfahren zum Erzeugen von partiell ausgebildeten Bereichen in einer oder mehreren Schichten (49) einer aus zwei oder mehren Schichten (41 bis 50) aufgebauten Mehrschichtfolie (4), eine Belichtungsstation und eine Fabrikationseinrichtung zur Durchführung des Verfahrens sowie eine durch ein solches Verfahren hergestellte Mehrschichtfolie (4). Die Mehrschichtfolie wird einer Beschichtungsstation zugeführt und mit einer Lackschicht aus strahlungshärtendem Lack beschichtet. Anschließend wird die Mehrschichtfolie einer Belichtungsstation zugeführt. In der Belichtungsstation läuft die Mehrschichtfolie über einen Maskenzylinder, der eine in dem Maskenzylinder angeordnete Strahlungsquelle aufweist, der die Strahlung der Strahlungsquelle partiell abdeckt. Die Mehrschichtfolie wird nun durch den Maskenzylinder derart partiell belichtet, daß der Lack an den bestrahlten Stellen aushärtet. In den nicht ausgehärteten Bereichen wird der Lack anschließend entfernt und Bereiche der auf die Lackschicht folgenden ein oder mehreren Schichten (49) demetallisiert, die nicht durch ausgehärteten Lack geschützt sind.

## Beschreibung

Die Erfindung betrifft ein Verfahren zum Erzeugen eines partiell ausgebildeten Bereichs in einer oder in mehreren Schichten einer aus zwei mehreren Schichten aufgebauten Mehrschichtfolie, eine Belichtungsstation und eine Fabrikationseinrichtung zur Erzeugung von partiell ausgebildeten Bereichen in einer oder in mehreren Schichten einer aus zwei oder mehreren Schichten aufgebauten Mehrschichtfolie und eine Mehrschichtfolie, insbesondere Prägefolie, Laminierfolie oder optisch variables Sicherungselement, mit einer partiell demetallisierten Schicht.

Mehrschichtfolien mit partiell demetallisierten Schichten haben vielfältige Anwendungsmöglichkeiten. Sie können beispielsweise zur Dekoration von Substrat-Oberflächen oder auch im Sicherheitsbereich zur Sicherung von Dokumenten, Karten und Geldscheinen Verwendung finden.

In GB 2136352A wird der Einsatz einer solchen Mehrschichtfolie für den Sicherheitsbereich beschrieben.

Die Mehrschichtfolie dient hier als Siegel, das auf zwei Oberflächen aufgebracht wird. Wenn diese beiden Oberflächen nach dem Aufbringen des Siegels voneinander entfernt werden, wenn so beispielsweise eine Verpackung einer Videokassette geöffnet wird, so wird dieses Siegel zerstört und damit das Öffnen der Verpackung kenntlich gemacht.

Dieses Sicherheitsprodukt wird hierbei wie folgt hergestellt:

Eine Plastikschicht aus transparentem Polyester wird mit einer Lackschicht bedruckt. In die derart erzeugte Lackschicht wird ein Sicherheitshologramm eingeprägt. Als nächster Schritt folgt eine ganzflächige Metallisierung der Oberfläche, in die das Sicherheitshologramm eingeprägt worden ist. Anschließend erfolgt eine partielle Demetallisierung dieser Oberfläche.

Die partielle Demetallisierung wird dadurch erreicht, daß auf diejenigen Bereiche der dünnen Metallschicht, die nach einer Demetallisierung verbleiben sollen, ein schützender Firnis aufgedruckt wird. Anschließend erfolgt die eigentliche Demetallisierung, bei der nun nur diejenigen Bereiche der dünnen Metallschicht entfernt werden, die nicht von der Firnisschicht geschützt sind.

An die Demetallisierung anschließend erfolgt ein Waschprozeß. In den darauf folgenden Schritten wird eine Klebeschicht aufgetragen und die so entstandene Mehrschichtfolie in kleine Stücke geschnitten, die jeweils die Funktion des oben beschriebenen Siegels erbringen können.

Der Erfindung liegt nun die Aufgabe zugrunde, die Herstellung einer Mehrschichtfolie mit einer partiell demetallisierten Schicht zu verbessern und eine Mehrschichtfolie mit einer partiell demetallisierten Schicht anzugeben, die kostengünstig produziert werden kann.

Diese Aufgabe wird gelöst von einem Verfahren zum Erzeugen eines partiell ausgebildeten Bereichs in ein oder mehreren Schichten einer aus zwei oder mehreren Schichten aufgebauten Mehrschichtfolie, bei dem die Mehrschichtfolie einer Beschichtungsstation zugeführt wird und mit einer Lackschicht aus strahlungshärtendem Lack, vorzugsweise aus UV aushärtendem Lack, beschichtet wird, die mit der Lackschicht beschichtete Mehrschichtfolie einer Belichtungsstation zugeführt wird, die Mehrschichtfolie in der Belichtungsstation über einen Maskenzylinder läuft, der eine in dem Maskenzylinder angeordnete Strahlungsquelle, vorzugsweise eine UV-Lampe, aufweist und der die Strahlung der Strahlungsquelle partiell abdeckt, die Mehrschichtfolie durch den Maskenzylinder partiell bestrahlt wird, so daß die Lackschicht in den bestrahlten Bereichen aushärtet, und dann die nicht ausgehärteten Bereiche der Lackschicht entfernt und Bereiche von auf die Lackschicht folgenden ein oder mehreren Schichten der Mehrschichtfolie demetallisiert werden, die nicht durch ausgehärtete Bereiche der Lackschicht geschützt sind. Die Erfindung betrifft weiter eine Belichtungsstation mit einem Maskenzylinder zur Führung einer mit einer Lackschicht aus strahlungshärtendem Lack beschichteten Mehrschichtfolie, bei dem in dem Maskenzylinder eine Strahlungsquelle zur Bestrahlung des strahlungshärtenden Lacks angeordnet ist und der Maskenzylinder derart ausgeformt ist, daß er die von der Strahlungsquelle abgestrahlte Strahlung partiell abdeckt, so daß die Lackschicht der über den Maskenzylinder geführten Mehrschichtfolie nur in durch den Maskenzylinder partiell bestrahlten Bereichen aushärtet. Die Erfindung betrifft weiter eine Fabrikationseinrichtung mit einer derartigen Belichtungsstation, die weiter eine Beschichtungsstation zur Beschichtung der Mehrschichtfolie mit einer Lackschicht aus strahlungshärtendem Lack und eine Demetallisierungsstation aufweist, die nicht ausgehärtete Bereiche der Lackschicht entfernt und Bereiche von auf die Lackschicht folgenden ein oder mehreren Schichten demetallisiert, die nicht durch ausgehärtete Bereiche der Lackschicht geschützt sind. Die Erfindung betrifft weiter eine Mehrschichtfolie, insbesondere eine Prägefolie, Laminierfolie oder ein optisch variables Sicherungselement, das eine partielle demetallisierte Schicht und eine auf der Oberfläche der partiell demetallisierten Schicht angeordnete Lackschicht aus einem ausgehärteten strahlungshärtenden Lack aufweist.

Die Aushärtung der strahlungshärtenden Lackschicht kann hierbei beispielsweise durch Röntgenstrahlung, Elektronenstrahlung, sichtbares Licht und durch UV-Licht bewirkt werden. Entsprechend der verwendeten Strahlung werden eine entsprechende Strahlungsquelle und ein entsprechender strahlungshärtender Lack verwendet.

Die Erfindung bringt den Vorteil mit sich, daß feiner und akkurater ausgestaltete partielle Demetallisierungsbereiche hergestellt werden können.

Erfolgt das Auftragen der Schutzlackschicht mittels eines Druckverfahrens, so können folgende Effekte die Gestalt eines demetallisierten Bereiches beeinflussen: Tiefdruckrasterwalzen weisen in der zu bedruckenden Fläche eine Vielzahl von kleinen Näpfchen auf, die den aufzudruckenden Schutzlack aufnehmen. Dies kann dazu führen, daß der Schutzlack teilweise nicht ausgedruckt wird und daß an den Rändern des Druckbereiches sägezahnförmige Strukturen entstehen. Diese beiden Effekte können zu einem unsauberen Arbeitsergebnis und vor allem zu einer unzureichenden Randauflösung führen.

Durch das erfindungsgemäße Verfahren werden diese Probleme vermieden. Die Gestalt eines demetallisierten Bereiches wird hier nicht mehr durch einen mechanischen Effekt bestimmt, der insbesondere die oben beschriebenen Unzulänglichkeiten bewirken kann. Die Gestaltung erfolgt vielmehr berührungslos und die Randauflösung ist prinzipiell nur durch die Wellenlänge der für die Aushärtung verwendeten Strahlung begrenzt.

Damit wird im Vergleich zum Stand der Technik ein gleich bleibend gutes, konturenscharfes Ergebnis erzielt.

Ein weiterer Vorteil der Erfindung besteht darin, daß flexibler auf Produktionsänderung reagiert werden kann und somit die Kosten des Herstellungsprozesses sinken. Der bei dem erfindungsgemäßen Verfahren verwendete Maskenzylinder ist kostengünstiger und schneller herzustellen, als die bisher verwendeten Tiefdruckrasterwalzen.

Ein weiterer Vorteil ergibt sich für den Sicherheitsbereich: Die Herstellung einer Tiefdruckrasterwalze erfordert die Beteiligung eines spezialisierten Zulieferbetriebes, so daß zusätzliche Sicherheitslücken entstehen können. Im Gegensatz hierzu ist der technologische Aufwand für die Herstellung eines Maskenzylinders geringer, so daß nicht zwingend auf einen spezialisierten Zulieferbetrieb zugegriffen werden muß.

Ein weiterer Vorteil der Erfindung besteht darin, daß dadurch die Produktionsgeschwindigkeit erhöht werden kann.

Vorteilhafte Ausgestaltungen der Erfindung sind in den Unteransprüchen bezeichnet.

Es ist zweckmäßig, den Maskenzylinder durch einen Motor anzutreiben, der den Maskenzylinder in Bewegungsrichtung der Mehrschichtfolie mit im wesentlichen konstanter Winkelgeschwindigkeit bewegt. Hierdurch wird eine konstante, zerrungsfreie Führung der Mehrschichtfolie über den Maskenzylinder gewährleistet und somit ein konstant gutes Belichtungsergebnis gewährleistet.

Vorteilhaft ist es, eine Steuerung vorzusehen, die die Winkelposition des Maskenzylinders erfaßt und die relative Winkelposition des Maskenzylinders zur Mehrschichtfolie derart verdreht, daß die partielle Bestrahlung durch den Maskenzylinder im Register erfolgt. Durch einen derart ausgestalteten Regelkreis ist es möglich, die Demetallisierungsbereiche genau im Register auszuführen und somit den Demetallisierungsprozeß mit weiteren Folienbearbeitungsprozessen zu synchronisieren. Dadurch wird ein insgesamt besseres Gesamtergebnis erzielt.

Ein vollflächiges Auftragen der Lackschicht aus einem strahlungshärtenden Lack bringt den Vorteil mit sich, daß nur ein einziges Auftragewerkzeug für unterschiedliche Mehrschichtfolien verwendet werden kann. So können mit diesem Auftragewerkzeug durch Veränderung des Maskenzylinders unterschiedliche Formen von Demetallisierungsmustern auf verschiedenartigen Mehrschichtfolien erzeugt werden.

Auch das teilflächige Aufbringen der Lackschicht aus strahlungshärtendem Lack kann für bestimmte Anwendungsfälle Vorteile mit sich bringen. Jedoch ist es möglich, nur solche Bereiche mit einem strahlungshärtenden Lack zu bedecken, für die auch tatsächlich später im wesentlichen die Metallisierung erhalten bleiben soll. Unter Umständen ist es mit einem solchen teilflächigen Auftragen der Lackschicht möglich, sowohl erhebliche Mengen von Lack als auch erhebliche Mengen von Komponenten einzusparen, die den nicht ausgehärteten Lack entfernen.

Zur Beschichtung der Mehrschichtfolie mit der Lackschicht aus strahlungshärtendem Lack ist es zweckmäßig, ein Tiefdruckverfahren einzusetzen. Mittels eines solchen Tiefdruckverfahrens können die für eine solche Lackschicht notwendigen Schichtdicken aufgebracht werden.

Weiter ist es zweckmäßig, die Mehrschichtfolie derart über den Maskenzylinder zu führen, daß der Maskenzylinder auf derjenigen Seite der Mehrschichtfolie angeordnet ist, auf die nicht die Lackschicht aus strahlungshärtendem Lack aufgetragen ist. Dadurch wird vermieden, daß Lack den Maskenzylinder verunreinigt.

Es ist vorteilhaft, in dem Maskenzylinder eine Abschirmung anzuordnen, die vermeidet, daß die von der Strahlungsquelle abgestrahlte Strahlung auf Teile der Mehrschichtfolie fällt, die nicht auf dem Maskenzylinder aufliegen. Hierdurch wird die Konturschärfe des Ergebnisses weiter verbessert. Es wird so vermieden, daß Streu-Strahlung auf den strahlungshärtenden Lack trifft und unter Umständen die nicht zu demetallisierenden Bereiche vergrößert. Weiter wird so eine Bündelung der von der Strahlungsquelle abgestrahlten Strahlung erreicht, so daß die Leistungsausbeute der Strahlungsquelle verbessert wird.

Die Effizienz des Herstellungsverfahrens kann weiter dadurch verbessert werden, daß die beiden Schritte "Entfernung des nicht ausgehärteten Lacks" und "Demetallisierung" in einem Arbeitsgang erbracht werden. Dies kann durch Verwendung einer Lauge realisiert werden, die sowohl die überschüssige Lackschicht abwäscht und gleichzeitig die darunterliegende Schicht oder die darunterliegenden Schichten demetallisiert.

Es ist zweckmäßig, in dem Maskenzylinder eine Halterung zum Aufspannen eines Negativfilms vorzusehen. Damit kann ein Negativfilm in den Maskenzylinder eingesetzt werden, wodurch eine besonders kostengünstige Gestaltung des Maskenzylinders erzielt wird.

Weiter hat es sich als besonders vorteilhaft erwiesen, den Maskenzylinder mit einer Hülse aus Plexiglas zu versehen, auf die Fotoschichten aufgetragen sind, die als Negativfilm belichtet worden sind. Durch diese Vorgehensweise ist ein besonders gleichmäßig konturenscharfes Arbeitsergebnis erzielbar.

Es ist zweckmäßig, Mehrschichtfolien zu verwenden, die über eine Replizierschicht mit einer diffraktiven Struktur und/oder mit Dünnfilmschichten ausgestattet sind. Durch die Kombination dieser Elemente mit den durch das erfindungsgemäße Verfahren erzielbaren, besonders konturenscharfen Demetallisierungsbereichen lassen sich optisch variable Sicherungselemente erzeugen, die einem hohen Sicherheitsstandard gerecht werden.

Im folgenden wird die Erfindung anhand von mehreren Ausführungsbeispielen unter Zuhilfenahme der beiliegenden Zeichnungen beispielhaft beschrieben.
- Fig. 1: zeigt eine schematische Darstellung einer Fabrikationseinrichtung und eines zugeordneten Herstellungsprozesses, der nach dem erfindungsgemäßen Verfahren durchgeführt wird.
- Fig. 2A bis Fig. 2d: zeigen Darstellung des Aufbaus einer Mehrschichtfolie, die durch das Verfahren nach Fig. 1 bearbeitet wird.
- Fig. 3: zeigt eine detaillierte Darstellung eines Maskenzylinders, der bei dem Verfahren nach Fig. 1 verwendet wird.
- Fig. 4: zeigt eine Darstellung des Aufbaus einer erfindungsgemäßen Mehrschichtfolie.

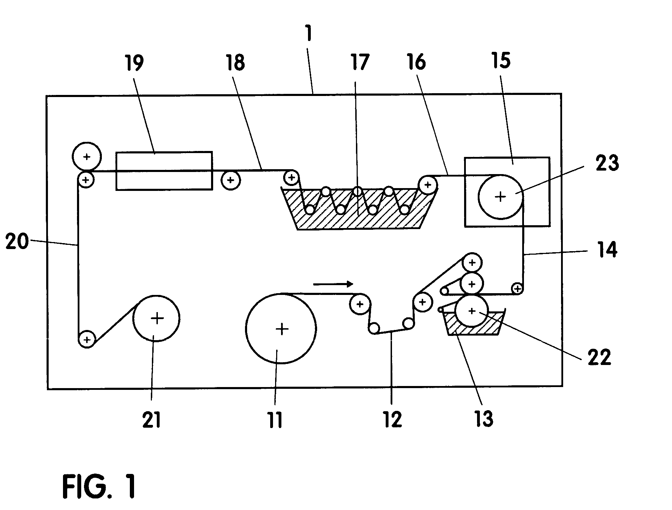

Fig. 1 zeigt eine Fabrikationseinrichtung 1, die der Erzeugung von partiell ausgebildeten Bereichen in einer oder in mehreren Schichten einer aus zwei oder mehreren Schichten aufgebauten Mehrschichtfolie dient. Die Fabrikationseinrichtung 1 weist eine Folienrolle 11, eine Beschichtungsstation 13, eine Belichtungsstation 15, eine Demetallisierungsstation 17, eine Trocknungsstation 19 und eine Folienrolle 21 auf. Weiter zeigt Fig. 1 mehrere Mehrschichtfolien 12, 14, 16, 18 und 20. Die Mehrschichtfolie 12 stellt die Mehrschichtfolie dar, die von der Folienrolle 11 abgespult wird und die der Beschichtungsstation 13 zugeführt wird. Die Mehrschichtfolie 14 stellt die von der Beschichtungsstation 13 bearbeitete Mehrschichtfolie 12 dar, die der Belichtungsstation 15 zugeführt wird. Die Mehrschichtfolie 16 stellt die von der Belichtungsstation 15 bearbeitete Mehrschichtfolie 14 dar, die der Demetallisierungsstation 17 zugeführt wird. Die Mehrschichtfolie 18 stellt die von der Demetallisierungsstation 17 bearbeitete Mehrschichtfolie 16 dar, die der Trocknungsstation 19 zugeführt wird. Die Mehrschichtfolie 20 stellt die durch die Trocknungsstation 19 getrocknete Mehrschichtfolie 18 dar, die auf der Folienrolle 21 aufgespult wird.

Der in Fig. 1 dargestellte Prozeß ist ein kontinuierlicher Prozeß. Es ist jedoch auch möglich, diesen Prozeß diskontinuierlich zu gestalten und beispielsweise zwischen ein oder mehreren Stationen die Mehrschichtfolie aufzurollen und zwischenzulagern.

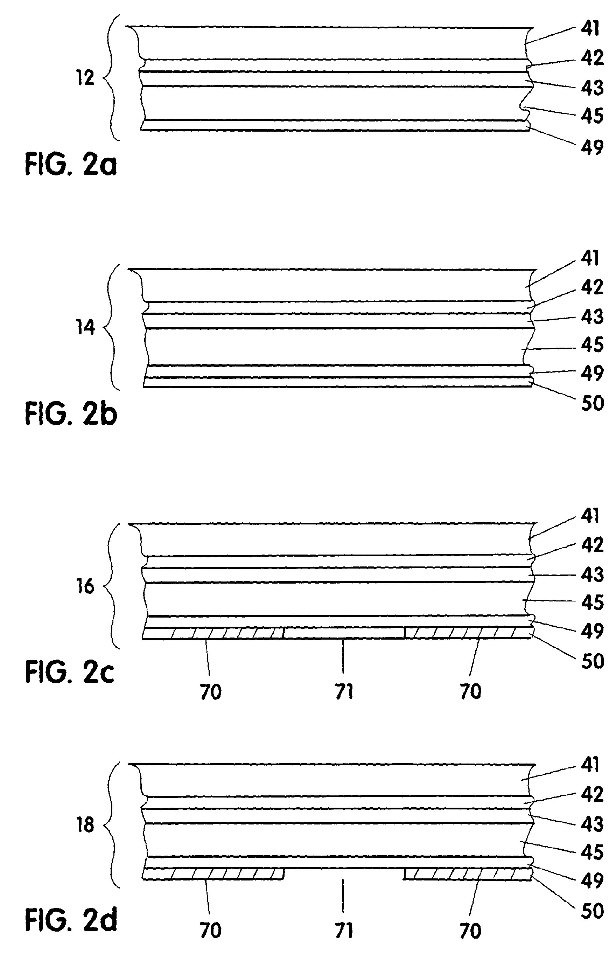

Der Aufbau der Mehrschichtfolie 12 ist beispielhaft in Fig. 2a gezeigt. Die Mehrschichtfolie weist einen Träger 41, eine Ablöseschicht 42, eine Replizierschicht 43 und eine Metallschicht 49 auf.

Der Träger 41 besteht beispielsweise aus PET. Der Träger 41 dient zum Aufbau der Mehrschichtfolie 12 und zum späteren Auftragen eines Teils der Mehrschichtfolie 12 auf ein anderes Substrat. Insofern stellt die Mehrschichtfolie 12 hier ein Vorprodukt einer Prägefolie, insbesondere einer Heißprägefolie, dar. Es ist auch möglich, auf die Ablöseschicht 42 zu verzichten und die Folie beispielsweise als Laminierfolie auszugestalten.

Die Ablöseschicht 42 dient dem Ablösen des aus den Schichten 43, 45 und 49 bestehenden Mehrschichtfolienkörpers von dem Träger 41. Die Ablöseschicht 42 ist beispielsweise aus einem Silicon-Material hergestellt. Weiter ist es möglich, daß die Ablöseschicht 42 zusätzlich die Funktion einer Schutzlackschicht erbringt.

Die Replizierschicht 45 ist aus einem durch Wärme formbaren Lack aufgebaut. Es ist jedoch auch möglich, die Replizierschicht 45 aus einem thermoplastischen Kunststoff, beispielsweise aus Polypropylen oder Polyester, herzustellen.

Bei der Metallschicht 49 handelt es sich um eine dünne Aluminiumschicht. Es ist auch möglich, die dünne Metallschicht aus einem anderen Material, beispielsweise aus Chrom, Silber, Kupfer, Eisen, Nickel oder einer Legierung mit diesen Materialien herzustellen.

Wie in Fig. 1 gezeigt, wird nun die Mehrschichtfolie 12 von der Folienrolle 11 abgerollt und über mehrere Führungen der Beschichtungsstation 13 zugeführt. In der Beschichtungsstation 13 wird die Mehrschichtfolie 12 mit einer Lackschicht vollflächig bedruckt, die aus einem UV-aushärtbaren Lack besteht.

Hierbei ist ein schnell aushärtender, nicht sauerstoffempfindlicher UV-Lack zu verwenden. Beispielsweise kann in der Beschichtungsstation 13 die Mehrschichtfolie 12 mit einem der folgenden UV-Lacke bedruckt werden: Monomere oder oligomere Polyesteracrylate, Polyetheracrylate, Urethanacrylate oder Epoxyacrylate sowie aminmodifizierte Polyesteracrylate, aminmodifizierte Polyetheracrylate oder aminmodifizierte Urethanacrylate.

Der UV-Lack ist hierbei in einer Schichtdicke von vorzugsweise 10 bis 100 µm auf die Mehrschichtfolie 12 aufzutragen.

Als Druckverfahren für das Aufdrucken der Lackschicht aus UV-aushärtbarem Lack wird vorzugsweise ein Tiefdruckverfahren verwendet. Mit einem solchen Verfahren läßt sich die für die Lackschicht benötigte Lackdicke gut erreichen und es ist möglich, den Herstellungsprozeß als kontinuierlichen Prozeß zu betreiben. Alternativ können jedoch auch andere Druckverfahren eingesetzt werden. Beispielhaft hierfür ist der Siebdruck, Tiefdruck, Flexo, Offset usw. zu nennen.

Wie in Fig. 2b gezeigt, liegt am Ausgang der Beschichtungsstation 13 die Mehrschichtfolie 14 vor, die zusätzlich eine auf der Metallschicht 49 vollflächig aufgetragene Lackschicht 50 aufweist.

Fig. 1 verdeutlicht nun, daß die so ausgestaltete Mehrschichtfolie 14 über ein oder mehreren Führungen der Belichtungsstation 15 zugeführt wird. Die Belichtungsstation 15 weist als wesentlichen Bestandteil einen Maskenzylinder 23 auf. Neben dem Maskenzylinder 23 weist die Belichtungsstation 15 noch ein oder mehrere Führungsmittel zur Zuführung der Mehrschichtfolie 15, einen Motor mit Getriebe, mehrere Sensoren, eine elektronische Steuerung und eine Abschirmung auf, die die Belichtungsstation 15 gegenüber dem Einfall von äußerem Fremdlicht und auch die Umgebung der Belichtungsstation 15 vor dem Austritt von UV-Licht aus der Belichtungsstation 15 abschirmt.

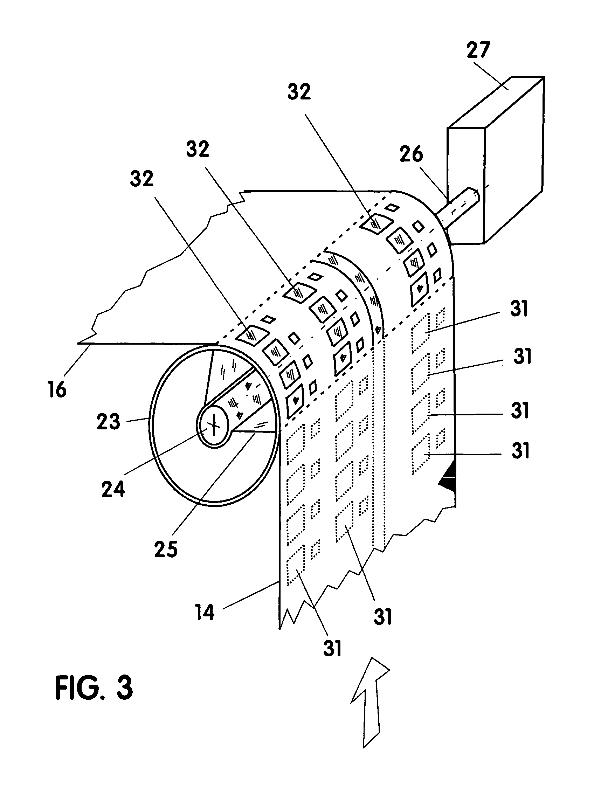

Der genaue Aufbau der Belichtungsstation 15 wird nun anhand von Fig. 3 erläutert.

Fig. 3 zeigt den Maskenzylinder 23, eine UV-Lampe 24, eine Abschirmung 25, die Folien 14 und 16, einen Motor 27, eine Welle 26 und mehrere Folienbereiche 31 der Mehrschichtfolie 14 und mehrere Bereiche 32 des Maskenzylinders 23.

Wie in Fig. 3 gezeigt, hat der Maskenzylinder 23 eine Länge, die mindestens der der Breite der ihm zugeführten Folienbahn entspricht. Der Durchmesser des Maskenzylinders 23 ist formatabhängig.

Der Durchmesser des Maskenzylinders 23 ist hierbei so zu wählen, daß abhängig von dem für die Lackschicht 50 verwendeten UV-Lack, der Lichtstärke der UV-Lampe 24 und der Arbeitsgeschwindigkeit eine ausreichend lange Belichtung der Lackschicht 50 gewährleistet wird.

Es bestehen mehrere prinzipielle Möglichkeiten, den Maskenzylinder 23 auszugestalten:

Zum einen ist es möglich, die Stirnseiten des Maskenzylinders als Halterungen für einen Negativfilm auszugestalten, der auf diese Auflageflächen aufgelegt und um den Maskenzylinder gespannt wird. Als Negativfilm ist hierbei ein relativ starrer Negativfilm zu verwenden, der vorzugsweise eine Dicke von 0,1 - 0,2 mm hat. Hierfür verwendbare Negativfilme sind beispielsweise UV-sensitive Kontaktfilme.

Weiter ist es möglich, nicht nur die Stirnseiten des Maskenzylinders als Auflageflächen für einen einzuspannenden Negativfilm zu verwenden, sondern auch innerhalb der von den Stirnseiten begrenzten Zylinderfläche Auflageflächen, beispielsweise in Form eines netzförmigen Trägers, vorzusehen. Für das Einspannen des Negativfilmes ist eine Haltevorrichtung vorzusehen, die zumindestens die Ecken des Negativfilmes fixiert.

Eine weitere Möglichkeit besteht darin, die Stirnflächen des Maskenzylinders als Auflagefläche für eine Plexiglas-Hülse vorzusehen, die eingeschoben und auf den Stirnseiten arretiert werden kann. Der Vorteil einer solchen Plexiglas-Hülse besteht darin, daß diese über eine recht hohe Festigkeit verfügt, so daß durch mechanische Belastungen keine Verzerrungen von Demetallisierungsbereichen entstehen können. Auf diese Plexiglas-Hülse sind Fotoschichten aufgetragen, die entsprechend der Fotoschichten eines Negativfilmes vor dem Aufschieben der Plexiglas-Hülse bearbeitet worden sind. So ist es beispielsweise möglich, die Plexiglas-Hülse mit UV-sensitiven Schichten zu beschichten und zu belichten.

Die UV-Lampe 24 ist im Inneren des Maskenzylinders 23 angeordnet. Es ist hierbei auch möglich, nicht nur eine einzige UV-Lampe, sondern zwei oder mehr UV-Lampen innerhalb des Maskenzylinders 23 anzuordnen. Dies kann vorteilhaft sein, um eine gleichmäßige Ausleuchtung des Maskenzylinders zu erreichen. In diesem Ausführungsbeispiel wird als UV-Lampe eine UV-Lampe mit einer Leistung von 2 kW eingesetzt. Wie bereits oben erwähnt, ist die Leistung der UV-Lampe auf die Arbeitsgeschwindigkeit, auf den Durchmesser des Maskenzylinders und auf die Eigenschaften des UV-Lacks abzustimmen.

Anstelle einer UV-Lampe kann für die UV-Lampe 24 auch eine andere Strahlungsquelle verwendet werden, die beispielsweise eine Röntgenstrahlung, eine Elektronenstrahlung oder sichtbares Licht verwendet.

Die Abschirmung 25 dient dazu, zu verhindern, daß das von der UV-Lampe 24 abgestrahlte Licht auf Bereiche der Mehrschichtfolien 14 und 16 fällt, die nicht auf dem Maskenzylinder 23 aufliegen. Die Abschirmung 25 wird hierbei vorteilhafterweise aus verspiegelten Flächen gebildet, die vollflächig im Inneren des Maskenzylinders 23 angeordnet sind und die bis dicht unterhalb der partiell lichtdurchlässigen Zylinderfläche des Maskenzylinders geführt sind. Hierbei ist die Abschirmung 25 so innerhalb des Maskenzylinders 23 befestigt, daß diese unabhängig von der Drehbewegung des Maskenzylinders 23 eine fixe Raumposition einnimmt. Der Öffnungswinkel der beiden reflektierenden Flächen, die die Abschirmung 25 bilden, entspricht hierbei vorzugsweise dem Bedeckungswinkel, mit dem die Folienbahn die Außenfläche des Maskenzylinders 23 umschließt.

Bei dem Motor 27 handelt es sich um einen Servomotor, der mit einem Getriebe ausgestattet ist. Dieser Servomotor treibt über die Welle 26 den Maskenzylinder 23 an. Die Drehrichtung, in der der Motor den Maskenzylinder 23 dreht, entspricht hierbei der Bewegungsrichtung der Folie. Weiter wird der Maskenzylinder von dem Motor mit einer im wesentlichen konstanten Winkelgeschwindigkeit bewegt, die der Bewegungsgeschwindigkeit der Folienbahn entspricht, so daß keine Spannungen innerhalb der Folienbahn auftreten.

Neben dem Motor 27 verfügt die Belichtungsstation 15 über Sensoren, die die Winkelposition des Maskenzylinders genau erfassen und über Sensoren, die auf der Folienbahn aufgebrachte Bildmarken erfassen. Durch die so erfaßten Werte ist es einer Auswerte-Elektronik möglich, die relative Position der von dem Maskenzylinder abgedeckten bzw. belichteten Bereiche zu den Bildmarken der Folienbahn zu bestimmen und so Belichtungsbereiche passergenau auszurichten. Die Steuerelektronik wertet die oben beschriebenen Eingangswerte hierzu in einer Regelschleife aus, die die relative Winkelposition des Maskenzylinders zur Mehrschichtfolie kontinuierlich derart zueinander verdreht, daß die partielle Belichtung durch den Maskenzylinder stets im Register erfolgt.

So ist es möglich, die von dem Maskenzylinder abgedeckten Bereiche 32 passergenau in die Folienbereiche 31 der Mehrschichtfolie 14 zu setzen.

Durch die Belichtung mittels des Maskenzylinders 23 entsteht aus der Mehrschichtfolie 14 die Mehrschichtfolie 16, in der, wie in Fig. 2c gezeigt, der Lack der Lackschicht 50 in den Bereichen 70 ausgehärtet ist und in dem Bereich 71 nicht ausgehärtet ist.

Die Mehrschichtfolie 16 wird nun über ein oder mehrere Führungsmittel der Demetallisierungsstation 17 zugeführt.

In der Demetallisierungsstation 17 durchläuft die Folienbahn zuerst ein oder mehrere Becken, die mit Wasser und/ oder einem Lösungsmittel gefüllt sind und die dem Abtrennen der nicht ausgehärteten Bereiche der Lackschicht 50 dienen. Nach diesem Entfernen des nicht ausgehärteten Lacks wird die Folienbahn durch ein oder mehrere Becken geführt, die mit Lauge oder Säure, beispielsweise mit Natronlauge (NaOH - Lösung) gefüllt sind. Diese Becken dienen dem eigentlichen Demetallisierungsprozeß.

Nach diesem Demetallisierungsprozeß durchläuft die Folienbahn ein oder mehreren Becken, die mit destilliertem Wasser gefüllt sind und die dem Spülen der Folienbahnen dienen. Wie in Fig. 2d dargestellt, wird durch die Demetallisierungsstation 17 aus der Mehrschichtfolie 16 die Mehrschichtfolie 18 erzeugt, in der in den Bereichen 70 die Metallschicht 49 und die ausgehärtete Lackschicht 50 vorliegt, und in der in dem Bereich 71 die Metallschicht 49 demetallisiert worden ist.

Die Folie 18 wird nun der Trocknerstation 19 zugeführt und getrocknet. Über Führungen wird die getrocknete Mehrschichtfolie 20 der Folienrolle 21 zugeführt und dort aufgespult.

Anstelle der Demetallisierung einer Metallschicht ist es auch möglich, mittels des oben beschriebenen Verfahrens Dünnfilmschichten, beispielsweise HRI- oder LRI-Schichten (HRI = High Refraction Index, LRI = Low Refraction Index), Absorptionsschichten und/oder Distanzschichten (λ ½- oder λ ¼-Schichten) zu demetallisieren. Der Begriff Demetallisierung ist somit nicht nur in Bezug auf Metallschichten zu verstehen, sondern in Bezug auf sämtliche Schichten zu verstehen, die mittels einer Lauge oder einer Säure entfernt werden können.

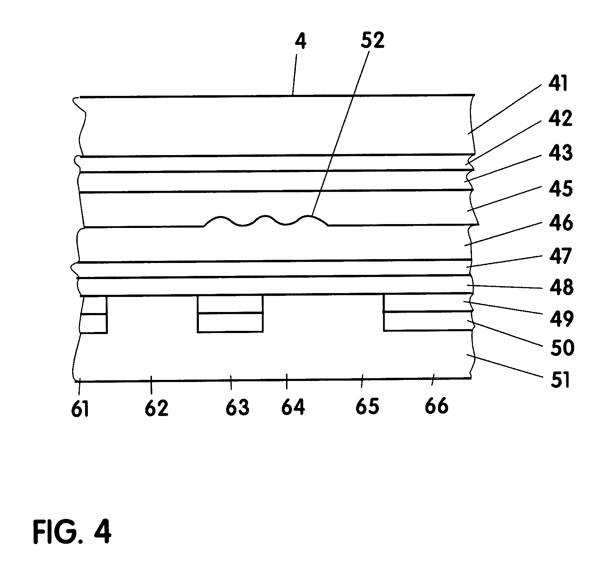

Fig. 4 zeigt nun beispielhaft den Aufbau einer erfindungsgemäß ausgestalteten Mehrschichtfolie.

Fig. 4 zeigt den Träger 41, die Ablöseschicht 42, die Schutzlackschicht 43, die Replizierschicht 45, in die eine diffraktive Struktur 52 eingeprägt ist, mehrere Dünnfilmschichten 46 bis 48, die Metallschicht 49, die Lackschicht 50 und eine Klebeschicht 51.

Der Aufbau der aus den Schichten 41 bis 51 bestehenden Mehrschichtfolie 4 entspricht dem Aufbau einer Prägefolie. Es ist jedoch auch möglich, daß eine erfindungsgemäße Mehrschichtfolie eine Laminierfolie ist, die nicht über den Träger 41 und die Schichten 42 und 43 verfügt, sondern anstelle dieser über eine Haftvermittlungsschicht verfügt.

Weiter ist es auch möglich, daß eine erfindungsgemäße Mehrschichtfolie ein optisch variables Sicherungselement oder ein Dekorationselement darstellt. Ein solches Element weist in seinem Aufbau zumindestens nicht den Träger 41 auf, der nach dem Aufbringen eines solchen Elementes entfernt wird. Wesentlicher Bestandteil eines solchen Elements ist eine partielle demetallisierte Schicht, beispielsweise eine partiell demetallisierte Metallschicht oder Dünnfilmschicht. Auf der einen Oberfläche dieser partiell demetallisierten Schicht ist nun eine Schicht aus einem ausgehärteten UV-Lack aufgetragen, der die nicht demetallisierten Bereiche der partiell demetallisierten Schicht abdeckt.

Die Mehrschichtfolie 4 verfügt über unterschiedliche Bereiche, die unterschiedliche optische Eigenschaften aufweisen:

In den Bereichen 61 und 66 hat die Mehrschichtfolie die Eigenschaft eines reflektierenden, von einem Dünnfilmeffekt, beispielsweise einer blickwinkelabhängigen Verschiebung, geprägten Bereiches. In den Bereichen 62 und 65 hat die Mehrschichtfolie 4 die Eigenschaft eines transparenten, von einem Dünnfilmeffekt überlagerten Elements. In dem Bereich 63 wird zum einen durch die diffraktive Struktur 52 ein diffraktiver Effekt, beispielsweise ein Hologramm, erzeugt, und zum anderen wird durch die darunterliegenden Dünnfilmschichten und durch das reflektierende Element ein reflektierender Dünnfilmeffekt erzeugt. In dem Bereich 64 stellt sich ein transparenter Dünnfilmeffekt ein, der von dem diffraktiven Effekt der diffraktiven Struktur 52 überlagert wird.

Anstelle einer diffraktiven Struktur 52 kann eine beliebige Mikro-Struktur verwendet werden, beispielsweise eine geprägte, aber nicht diffraktive Struktur mit einer Prägetiefe, die größer oder gleich 800 nm.

## Patentansprüche

1. Verfahren zum Erzeugen eines partiell ausgebildeten Bereichs in einer oder mehreren Schichten (49, 50) einer aus zwei oder mehreren Schichten (41 bis 51) aufgebauten Mehrschichtfolie (4, 12, 14, 16, 18, 20),
**dadurch gekennzeichnet,**
**daß** die Mehrschichtfolie (12) einer Beschichtungsstation (13) zugeführt wird und die Mehrschichtfolie (12) in der Beschichtungsstation (13) mit einer Lackschicht (50) aus strahlungshärtendem Lack beschichtet wird, daß die mit der Lackschicht (50) beschichtete Folie (14) einer Belichtungsstation (15) zugeführt wird, daß die Mehrschichtfolie (14) in der Belichtungsstation (15) über einen Maskenzylinder (23) läuft, der eine innerhalb des Maskenzylinders angeordnete Strahlungsquelle (24) aufweist und der die Strahlung der Strahlungsquelle (24) partiell abdeckt, daß die Mehrschichtfolie durch den Maskenzylinder (23) derart partiell bestrahlt wird, daß die Lackschicht (50) aus strahlungshärtendem Lack an den partiell belichteten Stellen aushärtet, und daß nicht ausgehärtete Bereiche der Lackschicht (50) entfernt werden und Bereiche von auf die Lackschicht folgenden ein oder mehreren Schichten (49) der Mehrschichtfolie demetallisiert werden, die nicht durch ausgehärtete Bereiche der Lackschicht (50) geschützt sind.

2. Verfahren nach Anspruch 1,
**dadurch gekennzeichnet,**
**daß** der Maskenzylinder (23) durch einen Motor (27) angetrieben wird, der den Maskenzylinder (23) in Bewegungsrichtung der Mehrschichtfolie (14, 16) mit im wesentlichen konstanter Winkelgeschwindigkeit bewegt.

3. Verfahren nach Anspruch 1,
**dadurch gekennzeichnet,**
**daß** eine Steuerung die Winkelposition des Maskenzylinders (23) erfaßt und die relative Winkelposition des Maskenzylinders (23) zur Mehrschichtfolie (14, 16) derart verdreht, daß die partielle Bestrahlung durch den Maskenzylinder (23) im Register erfolgt.

4. Verfahren nach Anspruch 1,
**dadurch gekennzeichnet,**
**daß** die Mehrschichtfolie (12) in der Beschichtungsstation (13) vollflächig mit der Lackschicht aus strahlungshärtendem Lack beschichtet wird.

5. Verfahren nach Anspruch 1,
**dadurch gekennzeichnet,**
**daß** die Mehrschichtfolie (12) in der Beschichtungsstation (13) teilflächig mit der Lackschicht aus strahlungshärtendem Lack beschichtet wird.

6. Verfahren nach Anspruch 1,
**dadurch gekennzeichnet,**
**daß** die Mehrschichtfolie (12) in der Beschichtungsstation (13) mittels eines Tiefdruckverfahrens mit der Lackschicht aus strahlungshärtendem Lack bedruckt wird.

7. Verfahren nach Anspruch 1,
**dadurch gekennzeichnet,**
**daß** die Mehrschichtfolie (14) derart über den Maskenzylinder (23) läuft, daß die dem Maskenzylinder gegenüberliegende Seite der Mehrschichtfolie (14) mit der Lackschicht aus strahlungshärtendem Lack beschichtet ist.

8. Verfahren nach Anspruch 1,
**dadurch gekennzeichnet,**
**daß** eine in dem Maskenzylinder (23) angeordnete Abschirmung (25) das Licht der Strahlungsquelle von dem Teil der Folie (14, 16) abschirmt, der nicht auf dem Maskenzylinder aufliegt.

9. Verfahren nach Anspruch 1,
**dadurch gekennzeichnet,**
**daß** die Demetallisierung und die Entfernung der nicht ausgehärteten Bereiche der Lackschicht in einer Station (17) durchgeführt werden, in der die Folie (16) durch ein oder mehrere mit einer Lauge gefüllte Becken bewegt wird.

10. Verfahren nach Anspruch 1,
**dadurch gekennzeichnet,**
**daß** die Strahlungsquelle (24) eine UV-Lampe ist.

11. Verfahren nach Anspruch 1,
**dadurch gekennzeichnet,**
**daß** der strahlungshärtende Lack ein durch UV-Strahlung aushärtender Lack ist.

12. Belichtungsstation (15) für die Erzeugung von partiell ausgebildeten Bereichen in einer oder in mehreren Schichten (49) einer aus zwei oder mehreren Schichten (41 bis 51) aufgebauten Mehrschichtfolie (4, 14, 16),
**dadurch gekennzeichnet,**
**daß** die Belichtungsstation (15) mit einem Maskenzylinder (23) zur Führung der mit einer Lackschicht (50) aus strahlungshärtendem Lack beschichteten Mehrschichtfolie (14) versehen ist, daß in dem Maskenzylinder (23) eine Strahlungsquelle (24) zur Belichtung des strahlungshärtenden Lacks angeordnet ist und daß der Maskenzylinder (23) derart ausgeformt ist, daß er die von der Strahlungsquelle (24) abgestrahlte Strahlung partiell abdeckt, so daß die Lackschicht (50) der über den Maskenzylinder (23) geführten Mehrschichtfolie (14) nur in durch den Maskenzylinder (23) partiell belichteten Bereichen aushärtet.

13. Belichtungsstation nach Anspruch 12,
**dadurch gekennzeichnet,**
**daß** der Maskenzylinder (23) eine Abschirmung (25) aufweist, die so ausgeformt ist, daß sie die Strahlung der Strahlungsquelle (24) von den Bereichen der Mehrschichtfolie (14, 15) abschirmt, die nicht auf dem Maskenzylinder (23) aufliegen.

14. Belichtungsstation nach Anspruch 12,
**dadurch gekennzeichnet,**
**daß** der Maskenzylinder (23) eine Halterung zum Aufspannen eines Negativfilms aufweist.

15. Belichtungsstation nach Anspruch 12,
**dadurch gekennzeichnet,**
**daß** der Maskenzylinder (23) eine Hülse aus Plexiglas aufweist, auf die Filmschichten aufgetragen sind.

16. Einrichtung (1) zur Erzeugung von partiell ausgebildeten Bereichen in ein oder mehreren Schichten (49) einer aus zwei oder mehreren Schichten (41 bis 51) aufgebauten Mehrschichtfolie (4, 12),
**dadurch gekennzeichnet,**
**daß** die Einrichtung (1) eine Beschichtungsstation zur Beschichtung der Mehrschichtfolie (12) mit einer Lackschicht (50) aus strahlungshärtendem Lack aufweist, daß die Einrichtung (1) eine Belichtungsstation (15) nach Anspruch 10 aufweist, und daß die Einrichtung (1) eine Demetallisierungsstation (17) zum Entfernen von nicht ausgehärteten Bereichen der Lackschicht (50) und zur Demetallisierung von Bereichen von auf die Lackschicht (50) folgenden ein oder mehreren Schichten (49) der Mehrschichtfolie aufweist, die nicht durch ausgehärtete Bereiche der Lackschicht (50) geschützt sind.

17. Mehrschichtfolie (4), insbesondere Prägefolie, Laminierfolie oder optisch variables Sicherungselement, mit einer partiell demetallisierten Schicht (49),
**dadurch gekennzeichnet,**
**daß** die Mehrschichtfolie (4) eine auf einer Oberfläche der partiell demetallisierten Schicht (49) angeordnete Lackschicht (50) aus einem ausgehärteten strahlungshärtenden Lack aufweist.

18. Mehrschichtfolie (4) nach Anspruch 17,
**dadurch gekennzeichnet,**
**daß** die Mehrschichtfolie eine Replizierschicht (46) mit einer diffraktiven und/ oder nicht diffraktiven Mikro-Struktur (52) aufweist.

19. Mehrschichtfolie (4) nach Anspruch 17,
**dadurch gekennzeichnet,**
**daß** die Mehrschichtfolie mittels eines Verfahrens nach Anspruch 1 hergestellt ist.
